# EUROPÄISCHE PATENTSCHRIFT

(11) **EP 0 589 275 B1**
(45) Veröffentlichungstag und Bekanntmachung des Hinweises auf die Patenterteilung: **31.05.1995**
(21) Anmeldenummer: 93114273.1
(22) Anmeldetag: 06.09.1993
(51) Int. Cl.: H05K 13/04, H05K 13/02

(54) **Zuführeinrichtung für gegurtete SMD-Bauelemente**
Feeder for belted SMD-components
Dispositif d'amenée de composants du type SMD insérés dans une bande

(30) Priorität: 23.09.1992 DE 4231857
(43) Veröffentlichungstag der Anmeldung: 30.03.1994
(73) Patentinhaber: SIEMENS AKTIENGESELLSCHAFT, 80333 München (DE)
(72) Erfinder: Schulz, Ralf, Dipl.-Ing., D-80809 München (DE); Goller, Hugo, Dipl.-Ing., D-80797 München (DE)

(56) Entgegenhaltungen:
- DD-A- 290 762
- DE-A- 3 736 530

## Beschreibung

Bei der automatischen Bestückung von Leiterplatten mit oberflächenmontierbaren Bauelementen, den sog. SMD-Bauelementen, erfolgt die Bereitstellung der Bauelemente über verschiedene Arten von Zuführeinrichtungen, wobei hier jedoch der Bereitstellung von gegurteten Bauelementen eine besondere Bedeutung zukommt. Die Anlieferform im Gurt (vgl. DIN IEC 286, Sept. 1987) ist besonders automatisierungsfreundlich, da die Bauelemente bereits vereinzelt sind und die Verpackung im Gurt weitgehende Sicherheit gegen Vertauschung gewährleistet. In den einzelnen Zuführeinrichtungen für gegurtete Bauelemente werden die Gurte mit den Bauelementen von einer Gurtspule abgespult und dann einer Entnahmeposition für die Bauelemente zugeführt. In der Entnahmeposition werden die Bauelemente dann mit der Saugpipette eines Bestückkopfes aufgenommen und in der vorgegebenen Bestückposition einer Leiterplatte abgesetzt (vgl. EP-A-0 013 979 und EP-A-0 016 368). Um die Bauelemente in der richtigen Entnahmeposition bereitzustellen, wird der Gurt mit Hilfe eines Transportrades angetrieben, dessen Transportstifte in die Transportlöcher des Gurtes eingreifen. Da die SMD-Bauelemente immer kleiner gebaut werden und außerdem möglichst hohe Bestückleistungen angestrebt werden, werden an Zuführeinrichtungen für gegurtete SMD-Bauelemente folgende Hauptforderungen gestellt:
- möglichst hohe Positioniergenauigkeit
- möglichst kurze Transportzeiten
- Gurttransporte z.B. wahlweise für eine 4 mm-Teilung und eine 2mm-Teilung der Bauelementefächer des Gurtes.

Der im Anspruch 1 angegebenen Erfindung liegt das Problem zugrunde, bei eine Zuführeinrichtung für gegurtete SMD-Bauelemente die vorstehend aufgeführten Forderungen mit einem geringen baulichen Aufwand zu realisieren.

Bei der erfindungsgemäßen Zuführeinrichtung bewirkt eine Umdrehung des Antriebsmotors einen Transportweg des Gurtes, der einem Bruchteil der Teilung der Bauelementefächer des Gurtes entspricht. Das bedeutet, daß bei einer oder mehreren vollständigen Umdrehungen des Antriebsmotors ein Transportweg des Gurtes bewirkt wird, der der Teilung der Bauelementefächer entspricht. Entspricht beispielsweise eine Umdrehung des Antriebsmotors einem Transportweg des Gurtes von 2 mm, so können alle Transportwege, die einem Vielfachen von 2 mm entsprechen, erreicht werden. Eine äußerst hohe Positioniergenauigkeit wird dabei dadurch erreicht, daß der Gurt zunächst über die angestrebte Position hinaus transportiert wird und daß dann durch Drehrichtungsumkehr des Antriebsmotors und durch das Anfahren eines mechanischen Anschlags die exakte Position reproduzierbar erreicht wird.

Vorteilhafte Ausgestaltungen der Erfindung sind in den Ansrpüchen 2 bis 4 angegeben.

Die Weiterbildung nach Anspruch 2 ermöglicht mit geringem Aufwand eine zuverlässige Realisierung des mechanischen Anschlags.

Die Ausgestaltung nach Anspruch 3 ermöglicht eine einfache und zuverlässige Erfassung der Umdrehungszahl des Antriebsmotors.

Die Weiterbildung nach Anspruch 4 verhindert mit dem Abschalten des Antriebsmotors eine zu starke Erwärmung von Antriebsmotor und Ansteuerung, wobei gleichzeitig auch der Energiebedarf reduziert wird.

Die Ausgestaltung nach Anspruch 5 reduziert schließlich die durch den mechanischen Anschlag verursachten Stöße auf ein Minimum.

Ein Ausführungsbeispiel der Erfindung ist in der Zeichnung dargestellt und wird im folgenden näher beschrieben.

Es zeigen:
Figur 1 das Grundprinzip einer Zuführeinrichtung für gegurtete Bauelemente in stark vereinfachter schematischer Darstellung,
Figur 2 den mechanischen Anschlag des Antriebsmotors der in Figur 1 dargestellten Zuführeinrichtung und
Figur 3 die Indexscheibe des Sensors zur Erfassung der Anzahl der Umdrehungen der Antriebsmotors des in Figur 1 dargestellten Zuführeinrichtung.

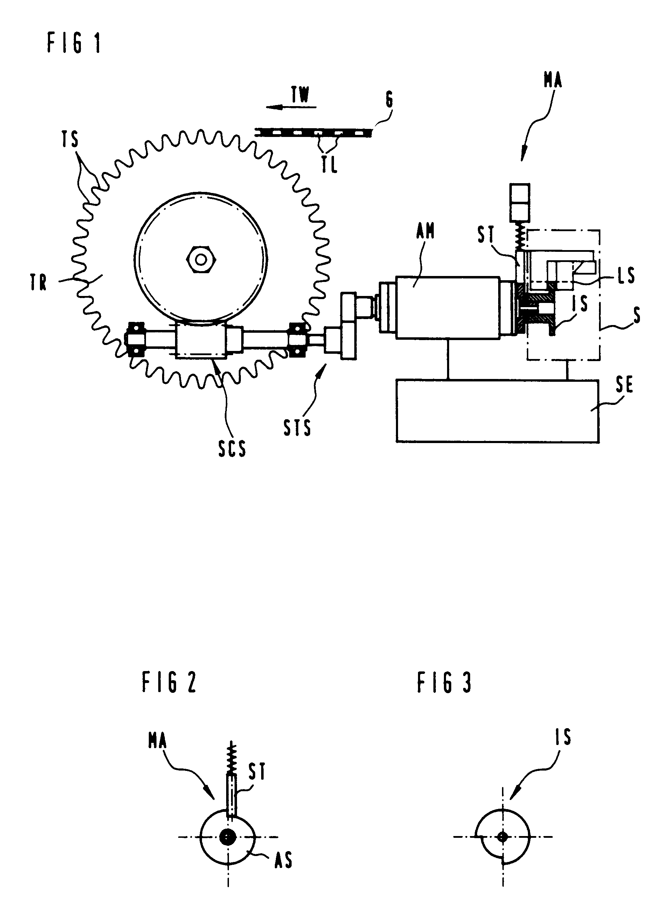

Figur 1 zeigt das Antriebsprinzip einer Zuführeinrichtung für gegurtete SMD-Bauelemente. Die Transportstifte TS eines Transportrades TR sind derart bemessen, daß sie für den schrittweisen Transport eines Gurtes G in dessen Transportlöcher TL eingreifen können. Im dargestellten Ausführungsbeispiel sind die Transportlöcher TL des Gurtes G in einem Teilungsabstand von 4 mm angeordnet.

Der Antrieb des Transportrades TR erfolgt über eine Stirnradstufe STS und eine schneckenradstufe SCS, deren Übersetzungen derart gewählt sind, daß eine volle Umdrehung des Antriebsmotors AM einen Transportweg TW des Gurtes G von 2 mm bewirkt. Dies bedeutet mit anderen Worten, daß zwei Umdrehungen des Antriebsmotors AM eine Drehung des Transportrades TR um den Teilungsabstand der Transportstifte TS und somit einen Transportweg TW des Gurtes G bewirkt, der einem Teilungsabstand der Transportlöcher TL des Gurtes G von 4 mm entspricht.

Auf der der Stirnratstufe STS gegenüberliegenden Seite des Antriebsmotors AM sind auf dessen nicht näher bezeichneter Antriebswelle das Anschlagrad AS eines mechanischen Anschlags MA und die Indexscheibe IS eines Sensors S zur Erfassung der Anzahl der Umdrehungen des Antriebsmotors AM angeordnet. Der mechanische Anschlag MA, dessen Wirkungsweise insbesondere aus Figur 2 ersichtlich ist, umfaßt neben der Anschlagscheibe AS einen gefederten Stift ST. Der Sensor S umfaßt neben der Indexscheibe IS eine damit zusammenwirkende Lichtschranke LS. Die Form der Indexscheibe IS ist aus der in Figur 3 gezeigten Draufsicht ersichtlich.

Die Steuerung des Antriebsmotors AM erfolgt über eine Steuereinrichtung SE, welche ihrerseits mit dem Sensor S verbunden ist.

Bei einer Rasterteilung der Bauelementefächer des Gurtes G von 2 mm wird nach der Entnahme eines SMD-Bauelements der Antriebsmotor AM eingeschaltet und wieder abgebremst, sobald der Sensor S der Steuereinrichtung SE eine vollständige Umdrehung des Antriebsmotors AM meldet. Der Gurt G wird dabei zunächst geringfügig über die angestrebte Position hinaus transportiert. Die Steuereinrichtung SE kehrt dann die Drehrichtung des Antriebsmotors AM um, wobei der dem Antriebsmotor AM zugeführter Strom nach einer Exponentialfunktion gegen Null gefahren wird. Sobald beim Rückwärtsdrehen die Anschlagscheibe AS die in Figur 2 dargestellte Stellung einer vollen Umdrehung erreicht hat, greift der gefederte Stift ST ein und stoppt den Antriebsmotor AM, der unmittelbar danach abgeschaltet wird. In dieser durch den mechanischen Anschlag MA definierten Position beträgt der Transportweg TW des Gurtes G exakt 2 mm und das nächste volle Bauelementefach befindet sich genau in der gewünschten Entnahmeposition.

Bei einer Rasterteilung der Bauelementefächer des Gurtes G von 4 mm wird nach der Entnahme eines SMD-Bauelementes der Antriebsmotor AM eingeschaltet und wieder abgebremst, sobald der Sensor S der Steuereinrichtung SE zwei vollständige Umdrehungen des Antriebsmotors AM meldet. Der Gurt G wird dabei zunächst geringfügig über die angestrebte Position hinaus transportiert. Die Steuereinrichtung SE kehrt dann die Drehrichtung des Antriebsmotors AM um, wobei der dem Antriebsmotor AM zugeführte Strom nach einer Exponentialfunktion gegen Null gefahren wird. Sobald beim Rückwärtsdrehen die Anschlagscheibe AS die in Figur 2 dargestellte Stellung der letzten vollen Umdrehung erreicht hat, greift der gefederte Stift ST ein und stoppt den Antriebsmotor AM, der unmittelbar danach abgeschaltet wird. In dieser durch den mechanischen Anschlag MA definierten Position beträgt der Transportweg TW des Gurtes G exakt 4 mm und das nächste volle Bauelementefach befindet sich genau in der gewünschten Entnahmeposition.

## Patentansprüche

1. Zuführeinrichtung für gegurtete SMD-Bauelemente, mit
- einem Transportrad (TR), dessen Transportstifte (TS) in die Transportlöcher (TL) des Gurtes (G) eingreifen,
- mindestens einem Antriebsmotor (AM), der das Transportrad (TR) derart antreibt, daß eine oder mehrere vollständige Umdrehungen des Antriebsmotors (AM) einen Transportweg (TW) des Gurtes (G) bewirken, der der Teilung der Bauelementefächer des Gurtes (G) entspricht,
- einem Sensor (S) zur Erfassung der Anzahl der Umdrehungen des Antriebsmotors (AM),
- einer Steuereinrichtung (SE), die nach einer vorgebbaren Anzahl von Umdrehungen des Antriebsmotors (Am) dessen Drehrichtung umkehrt und mit
- einem mechanischen Anschlag (MA), der die Rückwärtsdrehung des Antriebsmotors (AM) in der Stellung der letzten vollständigen Umdrehung des Antriebsmotors (AM) stoppt.

2. Zuführeinrichtung nach Anspruch 1,
**dadurch gekennzeichnet**,
daß der mechanische Anschlag (MA) durch einen gefederten Stift (ST) und eine Anschlagscheibe (AS) gebildet ist.

3. Zuführeinrichtung nach Anspruch 1 oder 2,
**dadurch gekennzeichnet**,
daß der Sensor (S) zur Erfassung der Anzahl der Umdrehungen des Antriebsmotors (AM) durch eine Indexscheibe (IS) und eine Lichtschranke (LS) gebildet ist.

4. Zuführeinrichtung nach einem der vorhergehenden Ansprüche,
**dadurch gekennzeichnet**,
daß die Steuereinrichtung (SE) den Antriebsmotor (AM) kurz nach Erreichen des mechanischen Anschlags (MA) abschaltet.

5. Zuführeinrichtung nach einem der vorhergehenden Ansprüche,
**gekennzeichnet durch** ein RC-Glied der Steuereinrichtung (SE), welches den dem Antriebsmotor (AM) zugeführten Strom bei der Rückwärtsdrehung nach einer Exponentialfunktion gegen Null fährt.

## Claims

1. Feed device for taped SMD components, having
- a transport wheel (TR) whose transport pins (TS) engage in the transport holes (TL) in the tape (G),
- at least one drive motor (AM), which drives the transport wheel (TR) in such a manner that one or more complete revolutions of the drive motor (AM) produce a transport movement (TW) of the tape (G) which corresponds to the pitch of the component compartments in the tape (G),
- a sensor (S) for detecting the number of revolutions of the drive motor (AM),
- a control device (SE) which reverses the rotation direction of the drive motor (AM) after it has carried out a number of revolutions which can be predetermined, and having
- a mechanical stop (MA) which stops the reverse rotation of the drive motor (AM) in the position of the last complete revolution of the drive motor (AM).

2. Feed device according to Claim 1, characterized in that the mechanical stop (MA) is formed by a sprung pin (ST) and a stop disc (AS).

3. Feed device according to Claim 1 or 2, characterized in that the sensor (S) for detecting the number of revolutions of the drive motor (AM) is formed by an indexing disc (IS) and a light barrier (LS).

4. Feed device according to one of the preceding claims, characterized in that the control device (SE) switches the drive motor (AM) off shortly after reaching the mechanical stop (MA).

5. Feed device according to one of the preceding claims, characterized by an RC element of the control device (SE), which RC element changes that current which is fed to the drive motor (AM) towards zero in accordance with an exponential function during the reverse rotation.

## Revendications

1. Dispositif d'amenée pour des composants SMD insérés dans une bande, comportant
- une roue de transport (TR), dont les picots de transport (TS) pénètrent dans les trous d'entraînement (TL) de la bande (G),
- au moins un moteur d'entraînement (AM), qui entraîne la roue de transport (TR) de telle sorte qu'une ou plusieurs rotations complètes du moteur d'entraînement (AM) conduisent à un entraînement de la bande (G) sur une distance (TW), qui correspond au pas des logements pour composants sur la bande (G),
- un capteur (S) pour détecter le nombre de rotations du moteur d'entraînement (AM),
- un dispositif de commande (SE), dont le sens de rotation s'inverse au bout d'un nombre pourvant être prédéterminé de rotations du moteur d'entraînement (Am), et
- une butée mécanique (MA), qui arrête la rotation rétrograde du moteur d'entraînement (AM) dans la position de la dernière rotation complète du moteur d'entraînement (AM).

2. Dispositif d'amenée suivant la revendication 1, caractérisé par le fait que la butée mécanique (MA) est formée par une tige (ST) suspendue élastiquement et un disque de butée (AS).

3. Dispositif d'amenée suivant la revendication 1 ou 2, caractérisé par le fait que le capteur (S) servant à détecter le nombre des rotations du moteur d'entraînement (AM) est formé par un disque d'index (IS) et un relais photoélectrique (LS).

4. Dispositif d'amenée suivant l'une des revendications précédentes, caractérisé par le fait que le dispositif de commande (SE) arrête le moteur d'entraînement (AM) peu après que la butée mécanique (MA) ait été atteinte.

5. Dispositif d'amenée suivant l'une des revendications précédentes, caractérisé par un circuit-RC du dispositif de commande (SE), qui fait tendre vers zéro le courant, envoyé au moteur d'entraînement (AM), sur une fonction exponentielle lors de la rotation rétrograde.
